# EUROPÄISCHE PATENTSCHRIFT

(11) **EP 1 112 676 B1**
(45) Veröffentlichungstag und Bekanntmachung des Hinweises auf die Patenterteilung: **06.03.2002**
(21) Anmeldenummer: 99942761.0
(22) Anmeldetag: 01.07.1999
(51) Int. Cl.: H05K 13/08

(54) **VERFAHREN UND VORRICHTUNG ZUM BEARBEITEN VON SUBSTRATEN**
METHOD AND DEVICE FOR PROCESSING SUBSTRATES
PROCEDE ET DISPOSITIF POUR USINER DES SUBSTRATS

(30) Priorität: 08.09.1998 DE 19840999
(43) Veröffentlichungstag der Anmeldung: 04.07.2001
(73) Patentinhaber: Siemens Production and Logistics Systems AG, 90475 Nürnberg (DE)
(72) Erfinder: SÖLLNER, Kai, D-95679 Waldershof (DE); PANZER, Stefan, D-81369 München (DE)
(86) Internationale Anmeldenummer: DE9901943
(87) Internationale Veröffentlichungsnummer: WO0015017

(56) Entgegenhaltungen:
- EP-A- 0 341 944
- EP-A- 0 456 218
- PATENT ABSTRACTS OF JAPAN vol. 1995, no. 4, 31. Mai 1995 (1995-05-31) & JP 07 022787 A (MATSUSHITA ELECTRIC IND CO), 24. Januar 1995 (1995-01-24)

## Beschreibung

Die Erfindung bezieht sich auf ein Verfahren und eine Vorrichtung zum Bearbeiten von Substraten, insbesondere zum Bestücken der Substrate mit elektrischen Bauelementen.

Bei der automatischen Bestückung von Substraten (beispielsweise Leiterplatten oder Keramiksubstraten) mit SMD-Bauelementen (SMD=Surface Mounted Device) werden die einzelnen Bauelemente mittels eines Bestückkopfes aus einem Magazin oder einer Zuführeinrichtung entnommen und dann in einer vorgegebenen Lage auf dem Substrat positioniert. Die Substrate werden dabei aus einem Magazin entnommen und auf eine Bearbeitungsposition in einem ersten Bearbeitungsautomaten transportiert. In diesem ersten Bearbeitungsautomaten wird beispielsweise Kleber an den Stellen des Substrates aufgetragen, an denen in einem zweiten Bearbeitungsautomaten Bauelemente aufgesetzt werden sollen. Zu diesem zweiten Bearbeitungsautomaten werden die Substrate mit einer Transportvorrichtung transportiert.

Zum positionsgenauen Bestücken ist dabei die Kenntnis der Lage des Substrates erforderlich. Dafür werden auf dem Substrat Lagemarkierungen (beispielsweise Kreuze) aufgebracht, die im Bearbeitungsautomaten von einer Kamera aufgenommen und in einer der Kamera nachgeschalteten Bildauswerteeinheit auf ihre relative Lage zum Bearbeitungsautomaten ausgewertet werden.

Auf einem Substrat können mehrere Schaltungen vorgesehen sein, die ihrerseits jeweils Schaltungsmarkierungen aufweisen, die vermessen werden, um beispielsweise den Einfluß von Verzügen im Substrat auf die Bestückgenauigkeit zu reduzieren. Zusätzlich werden nicht funktionsfähige Schaltungen durch Funktionsmarkierungen, sogenannte Ink-Punkte, markiert. Dadurch erkennt die Kamera mit der nachgeschalteten Bildauswerteeinheit die fehlerhafte Schaltung, und es erfolgt keine Bestückung mit Bauelementen.

Werden nun komplexe Schaltungen mit vielen unterschiedlichen Typen von Bauelementen bestückt, so werden mehrere Bearbeitungsstationen in einer Linie angeordnet, wie es beispielsweise aus US 5,692,292 bekannt ist, zwischen denen die Substrate transportiert werden. In jeder Bearbeitungsstation werden dabei die Lagemarkierungen, die Schaltungsmarkierungen und die Funktionsmarkierungen vermessen und ausgewertet, was einen entsprechend hohen Zeitaufwand erfordert.

Methoden bzw. Vorrichtungen zur Erkennung der Markierungen sind beispielsweise aus WO 97/38567 oder aus DE 41 36 543 bekannt. Die Nutzung solcher Vorrichtungen in Bearbeitungslinien ist nicht beschrieben.

Darüber hinaus ist es bei Bestückautomaten der Firma FUJI-Machine bekannt, die Substrate auf Werkstückträgern zu transportieren, die mit genauen Fixiermitteln versehen sind. Dadurch entfällt das Vermessen in nachfolgenden Bestückautomaten, jedoch muß eine große Anzahl von teuren Werkstückträgern vorgehalten werden.

Aus DE 42 33 438 ist eine Einrichtung mit einem Transportsystem zwischen einzelnen Bearbeitungsstationen für Werkstücke auf Werkstückträgern bekannt, bei der zur Überprüfung einzelner Montageschritte Bildverarbeitungsstationen vorgesehen sind, die mit weiteren Bearbeitungsstationen über einen die Bearbeitungsstationen steuernden Computer verknüpft sein können. Dabei haben die Bildverarbeitungsstationen je nach ihrer Position im Transportsystem unterschiedliche Aufgaben. So ist zum einen vorgesehen, mit Hilfe der Bildverarbeitungsstationen die in den Werkstückträgern befindlichen Werkstücke auf korrekte Lage und auf Vollzähligkeit zu überprüfen und bei einem festgestellten Fehler ein Signal abzugeben. Daraufhin kann der Fehler behoben werden. Eine direkte Weiterbearbeitung der Werkstücke läßt sich nicht entnehmen. Zum zweiten ist vorgesehen, daß die einzelnen Montageschritte durch weitere Bildverarbeitungsstationen nach der jeweiligen Montage überprüft werden. Auch hier wird im Fehlerfall ein Signal abgegeben. Die Ergebnisse der Überprüfungen werden dabei über einen PC an die weiteren Bearbeitungsstationen übermittelt. Dabei ist nicht offenbart, in welcher Art und Weise die nachfolgenden Bearbeitungsstationen diese Ergebnisse verwenden. Es wird nicht geschildert, ob die Bearbeitung bei einem Fehler unterbrochen wird oder welche anderen Maßnahmen ergriffen werden. An diesen Stellen im Prozeßablauf wird auch keine Lagebestimmung der Werkstücke durchgeführt, so daß die Lage alleine über die Position der Werkstückträger definiert ist. Eine solche bekannte Einrichtung ist daher für das Bearbeiten von Substraten ohne Werkstückträger nicht geeignet und außerdem ist die reine Fehlererkennung nicht ausreichend, um anschließend eine Weiterbearbeitung zu ermöglichen.

Es ist die Aufgabe der Erfindung, ein Verfahren und eine Vorrichtung zum Bearbeiten von Substraten anzugeben, bei dem bei geringem Vorrichtungsaufwand der Zeitaufwand zum Vermessen der zum Bearbeiten verwendeten geometrischen Daten des Substrates minimiert wird.

Die Aufgabe wird erfindungsgemäß gelöst durch ein Verfahren mit den Merkmalen des Anspruchs 1 und eine Vorrichtung mit den Merkmalen des Anspruchs 5.

Dabei ist gemäß Anspruch vorgesehen, daß die geometrischen Daten des Substrats nur im ersten einer Reihe von Bearbeitungsautomaten vermessen werden und die geometrischen Daten an die weiteren Bearbeitungsautomaten übermittelt werden. Dadurch müssen nur noch die Lagekoordinaten des Substrates in jedem Bearbeitungsautomaten vermessen werden, was den Zeitaufwand zum Vermessen dem Zeitaufwand bei der Verwendung von Werkstückträgern annähert, so daß auf Werkstückträger verzichtet werden kann.

In vorteilhafter Weise werden die geometrischen Daten gemäß Anspruch 2 durch das optische Vermessen von auf dem Substrat angebrachten Markierungen ermittelt, was zu einer ausreichend genauen Positionsbestimmung führt.

Die Lagekoordinaten werden gemäß Anspruch 3 ebenfalls einfach und ausreichend genau optisches Vermessen von auf dem Substrat aufgebrachten Markierungen ermittelt.

In einer bevorzugten Ausführungsform nach Anspruch 4 werden die geometrischen Daten auch an weitere Bearbeitungsautomaten, die vom Substrat durchlaufen werden, übermittelt, was zu einem weiter verringerten Zeitaufwand führt.

Die erfindungsgemäße Vorrichtung weist gemäß Anspruch 5 ein Bussystem für die Übertragung der Meßdaten zwischen den Steuereinrichtungen der Bearbeitungsautomaten auf und benutzt zum Ermitteln der Lagekoordinaten und der geometrischen Daten dieselbe Meßstation.

Anhand eines Ausführungsbeispiels wird die Erfindung gemäß den Figuren der Zeichnung näher erläutert. Dabei zeigen
Figur 1 ein Substrat mit schematisch angedeuteten Markierungen und
Figur 2 schematisch zwei Bearbeitungsautomaten und Substrate in der Draufsicht.

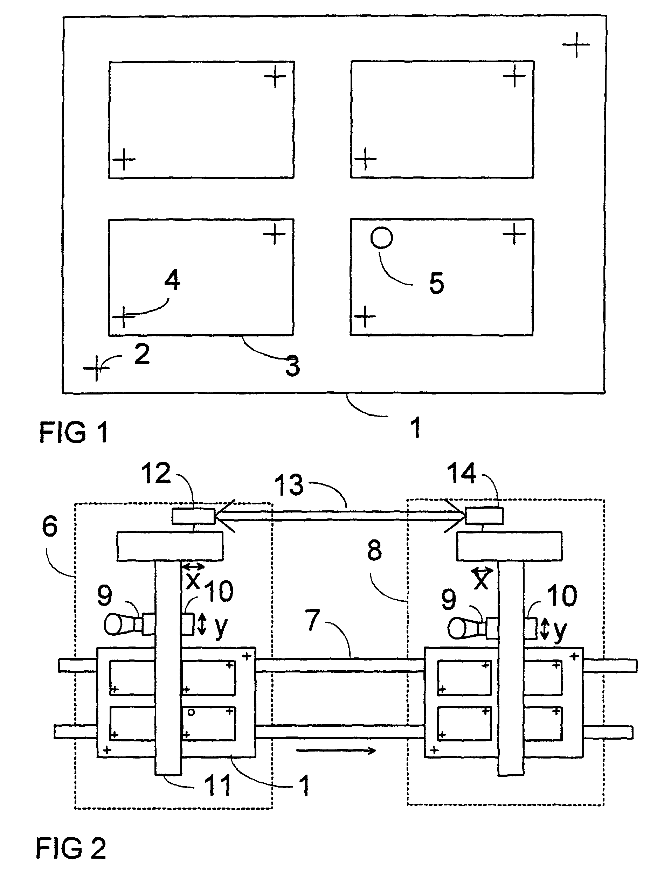

In Figur 1 ist ein Substrat 1, beispielsweise eine Leiterplatte oder ein Keramiksubstrat, mit zwei in gegenüberliegenden Ecken aufgebrachten Kreuzen als Lagemarkierungen 2 aufgebracht. Auf dem Substrat 1 befinden sich vier Schaltungen 3, die ihrerseits Kreuze als Schaltungsmarkierungen 4 aufweisen. Eine Schaltung weist zusätzlich eine Funktionsmarkierung 5, einen sogenannte "ink-Punkt" auf, der aufgebracht wurde, um zu dokumentieren, daß diese Schaltung fehlerhaft ist und nicht bestückt werden sollte.

In Figur 2 sind schematisch ein erster Bearbeitungsautomat 6 und ein zweiter Bearbeitungsautomat 8 dargestellt, die über einen Transportmechanismus 7 verbunden sind. Das Substrat wird über diesen Transportmechanismus 7, beispielsweise ein Riemensystem, nach dem Bearbeiten im ersten Bearbeitungsautomat 6 in den zweiten Bearbeitungsautomat 8 transportiert. In den Bearbeitungsautomaten 6,8 wird das Substrat 1 zumindest temporär fixiert, um die Bearbeitung vorzunehmen. Die beiden Bearbeitungsautomaten können dabei beispielsweise als eine Klebestation und ein Bestückautomat oder auch als zwei Bestückautomaten, von denen jeder einen bestimmten Vorrat an Bauelementtypen aufweist, ausgebildet sein. Weitere Bearbeitungsstationen können sich in analoger Form anschließen.

Mittels einer Meßstation 9, beispielsweise einer Kamera mit nachgeschalteter Bildauswerteeinheit, werden die Markierungen 2,4,5 im ersten Bearbeitungsautomaten vermessen und die zugehörigen Lagekoordinaten und geometrischen Daten der Schaltungsmarkierungen 4 und der Funktionsmarkierungen 5 in der ersten Steuereinrichtung 12, die dem ersten Bearbeitungsautomaten 6 zugeordnet ist, abgespeichert. Die Meßstation 9 ist an einem Bestückkopf 10 befestigt, der über ein Portalsystem 11 über dem Substrat in x-y-Richtung beweglich ist. Die Lagekoordinaten und die geometrischen Daten werden beim nachfolgenden Bearbeiten des Substrates 1 in dem ersten Bearbeitungsautomaten 6 berücksichtigt.

Anschließend wird das Substrat 1 über den Transportmechanismus 7 in den zweiten Bearbeitungsautomaten 8 transportiert und dort ebenfalls für die Bearbeitung zumindest temporär fixiert. Um eine gegenüber der relativen Lage zwischen dem Sub-strat 1 und dem ersten Bearbeitungsautomaten 6 unterschiedliche relative Lage zwischen dem Substrat 1 und dem zweiten Bearbeitungsautomaten 8 zu ermitteln, werden mit Hilfe der Meßstation 9 des zweiten Bearbeitungsautomaten 8 die Lagekoordinaten anhand der Lagemarkierungen 2 ermittelt. Die übrigen geometrischen Daten der Schaltungsmarkierungen 4 und der Funktionsmarkierungen 5 werden von der ersten Steuereinrichtung 12 an die zweite Steuereinrichtung 14 übermittelt, die dem zweiten Bearbeitungsautomaten 8 zugeordnet ist. Die Übermittlung kann dabei direkt von der ersten 12 zur zweiten Steuereinrichtung 14 oder auch über eine zwischengeschaltete Zentrale (nicht dargestellt) erfolgen. Dadurch brauchen diese geometrischen Daten nicht erst im zweiten Bearbeitungsautomaten 8 ermittelt werden, was somit zu einem geringeren Zeitaufwand und damit einer höheren Bearbeitungsgeschwindigkeit führt.

## Patentansprüche

1. Verfahren zum Bearbeiten von Substraten (1) in mindestens zwei Bearbeitungsautomaten (6,8), insbesondere zum Bestücken der Substrate (1) mit elektrischen Bauelementen,
wobei im ersten Bearbeitungsautomaten (6)
- das Substrat(1) zumindest temporär fixiert wird,
- Lagekoordinaten des Substrats (1) im ersten Bearbeitungsautomaten (6), und zusätzliche geometrische Daten des Substrats (1) ermittelt werden,
- das Substrat (1) unter Berücksichtigung der Lagekoordinaten und der geometrischen Daten bearbeitet wird,
das Substrat (1) zum zweiten Bearbeitungsautomaten (8) transportiert und dort zumindest temporär fixiert wird,
die geometrischen Daten an den zweiten Bearbeitungsautomaten (8) übermittelt werden,
die Lagekoordinaten des Substrates (1) im zweiten Bearbeitungsautomaten (8) bestimmt werden und
das Substrat (1) unter Berücksichtigung der Lagekoordinaten im zweiten Bearbeitungsautomaten (8) und der übermittelten geometrischen Daten bearbeitet wird.

2. Verfahren zum Bearbeiten von Substraten (1) nach Anspruch 1,
**dadurch gekennzeichnet,**
**daß** die geometrischen Daten durch optisches Vermessen von auf dem Substrat (1) angebrachten Markierungen (4,5) ermittelt werden.

3. Verfahren zum Bearbeiten von Substraten (1) nach einem der Ansprüche 1 oder 2,
**dadurch gekennzeichnet,**
**daß** die Lagekoordinaten durch optisches Vermessen von auf dem Substrat (1) angebrachten Lagemarkierungen (2) ermittelt werden.

4. Verfahren zum Bearbeiten von Substraten (1) nach einem der Ansprüche 1, 2 oder 3,
**dadurch gekennzeichnet,**
**daß** beim Bearbeiten des Substrats (1) in mehr als zwei Bearbeitungsautomaten die geometrischen Daten auch an die weiteren Bearbeitungsautomaten übertragen werden.

5. Vorrichtung zum Bearbeiten von Substraten (1)
mit mindesten zwei Bearbeitungsautomaten (6,8),
mit einer Transportvorrichtung (7) für Substrate (1) zwischen den Bearbeitungsautomaten (6,8),
mit einer Meßstation (9) im ersten der beiden Bearbeitungsautomaten (6,8) zum Ermitteln von Meßdaten von Markierungen (2,4,5) auf den Substraten (1) und zum Ermitteln von Lagekoordinaten des Substrats (1) im ersten der beiden Bearbeitungsautomaten (6,8),
mit jeweils einer Steuereinrichtung (12, 14) zum Steuern der jeweiligen Bearbeitungsautomaten (6,8) und zum Abspeichern der Meßdaten
**gekennzeichnet durch**
ein Bussystem (13) zwischen den Steuereinrichtungen (12,14) der Bearbeitungsautomaten (6,8) zur Übertragung der Meßdaten der Markierungen.

## Claims

1. Method for processing substrates (1) in at least two automatic processing machines (6, 8), in particular for populating the substrates (1) with electric components, in which, in the first automatic processing machine (6)
- the substrate (1) is fixed, at least temporarily,
- position co-ordinates of the substrate (1) in the first automatic processing machine (6), and additional geometric data about the substrate (1), are determined,
- the substrate (1) is processed, taking into account the position co-ordinates and the geometric data,
the substrate (1) is transported to the second automatic processing machine (8) and is fixed there, at least temporarily,
the geometric data are transmitted to the second automatic processing machine (8),
the position co-ordinates of the substrate (1) are determined in the second automatic processing machine (8) and
the substrate (1) is processed, taking into account the position co-ordinates in the second automatic processing machine (8) and the transmitted geometric data.

2. Method for processing substrates (1) according to Claim 1, **characterized in that** the geometric data are determined by means of optical surveying of markings (4, 5) applied to the substrate (1).

3. Method for processing substrates (1) according to either of Claims 1 and 2, **characterized in that** the position co-ordinates are determined by means of optical surveying of position markings (2) applied to the substrate (1).

4. Method for processing substrates (1) according to one of Claims 1, 2 or 3,
**characterized in that** when the substrate (1) is processed in more than two automatic processing machines, the geometric data are also transferred to the further automatic processing machines.

5. Device for processing substrates (1)
having at least two automatic processing machines (6, 8),
having a transport device (7) for substrates (1) between the automatic processing machines (6, 8), having a measuring station (9) in the first of the two automatic processing machines (6, 8) for determining measured data from markings (2, 4, 5) on the substrates (1) and for determining position co-ordinates of the substrate (1) in the first of the two automatic processing machines (6, 8),
having a control device (12, 14) in each case for controlling the respective automatic processing machines (6, 8) and for storing the measured data,
**characterized by**
a bus system (13) between the control devices (12, 14) of the automatic processing machines (6, 8), for transferring the measured data about the markings.

## Revendications

1. Procédé destiné à l'usinage de substrats (1) dans au moins deux robots d'usinage (6, 8), notamment à l'équipement des substrats (1) avec des composants électriques,
dans lequel,
dans le premier robot d'usinage (6),
- le substrat (1) est fixé au moins temporairement,
- sont déterminées les coordonnées de position du substrat (1) dans le premier robot d'usinage (6) et des données géométriques supplémentaires du substrat (1),
- le substrat (1) est usiné en tenant compte des coordonnées de position et des données géométriques,
le substrat (1) est transporté vers le deuxième robot d'usinage (8) et y est fixé au moins temporairement,
les données géométriques sont transmises au deuxième robot d'usinage (8), les coordonnées de position du substrat (1) dans le deuxième robot d'usinage (8) sont déterminées et
le substrat (1) est usiné en tenant compte des coordonnées de position dans le deuxième robot d'usinage (8) et des données géométriques transmises.

2. Procédé destiné à l'usinage de substrats (1) selon la revendication 1
**caractérisé par le fait**
**que** les données géométriques sont déterminées par mesure optique de marquages (4, 5) appliqués sur le substrat (1).

3. Procédé destiné à l'usinage de substrats (1) selon l'une des revendications 1 ou 2
**caractérisé par le fait**
**que** les coordonnées de position sont déterminées par mesure optique de marquages de position (2) appliqués sur le substrat (1).

4. Procédé destiné à l'usinage de substrats ( 1) selon l'une des revendications 2 ou 3
**caractérisé par le fait**
**que**, pour l'usinage du substrat ( 1) dans plus de deux robots d'usinage, les données géométriques sont aussi transmises aux autres robots d'usinage.

5. Dispositif destiné à l'usinage de substrats (1) comportant
au moins deux robots d'usinage (6, 8),
un dispositif de transport (7) pour des substrats (1) entre les robots d'usinage (6, 8),
une station de mesure dans le premier des deux robots d'usinage (6, 8) destinée à déterminer des données de mesure de marquages (2, 4, 5) sur les substrats (1) et à déterminer des coordonnées de position du substrat (1) dans le premier des deux robots d'usinage (6, 8),
pour chaque robot d'usinage, un dispositif de commande (12, 14) pour la commande de chaque robot d'usinage (6, 8) et pour la mémorisation des données de mesure
**caractérisé par**
un système de bus (13) entre les dispositifs de commande (12, 14) des robots d'usinage (6, 8) destiné à la transmission des données de mesure des marquages.
